(19) Europäisches Patentamt
European Patent Office
Office européen des brevets

(11) **EP 3 824 305 B1**

(12) **FASCICULE DE BREVET EUROPEEN**

(45) Date de publication et mention de la délivrance du brevet:
**06.11.2024 Bulletin 2024/45**

(21) Numéro de dépôt: **19759641.4**

(22) Date de dépôt: **16.07.2019**

(51) Classification Internationale des Brevets (IPC):
**G01R 31/36** *(2020.01)* **G01R 31/367** *(2019.01)*
**G01R 31/392** *(2019.01)*

(52) Classification Coopérative des Brevets (CPC):
**G01R 31/392; G01R 31/3648; G01R 31/367;**
**Y02E 60/10**

(86) Numéro de dépôt international:
**PCT/FR2019/051784**

(87) Numéro de publication internationale:
**WO 2020/016522 (23.01.2020 Gazette 2020/04)**

(54) **PROCÉDÉ ET DISPOSITIF DE DÉTERMINATION D'UNE DURÉE LIMITE D'UTILISATION D'UNE BATTERIE**

**VERFAHREN UND VORRICHTUNG ZUR BESTIMMUNG EINER MAXIMALEN VERWENDUNGSDAUER EINER BATTERIE**

**METHOD AND DEVICE FOR DETERMINING A MAXIMUM DURATION OF USE OF A BATTERY**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.07.2018 FR 1856605**

(43) Date de publication de la demande:
**26.05.2021 Bulletin 2021/21**

(73) Titulaire: **Safran Electrical & Power**
**31702 Blagnac Cedex (FR)**

(72) Inventeur: **SAYEGH, Marie**
**77550 Moissy Cramayel (FR)**

(74) Mandataire: **Casalonga**
**Casalonga & Partners**
**Bayerstraße 71/73**
**80335 München (DE)**

(56) Documents cités:
**US-A1- 2016 259 014 US-A1- 2016 349 330**

**Description**

La présente invention concerne, de manière générale, la surveillance de l'état de fonctionnement de batteries d'accumulateurs électriques et, en particulier, la surveillance de l'état de fonctionnement de batteries embarquées à bord d'un aéronef.

Plus particulièrement, l'invention concerne la surveillance de la durée de vie restante d'une batterie en prédisant une durée limite d'utilisation de la batterie, vis à vis notamment d'un ou plusieurs profils d'utilisation de la batterie. Il s'agit en particulier de prédire l'instant auquel la batterie devra suivre une opération de maintenance.

Il existe un certain nombre de paramètres susceptibles d'avoir une influence sur la durée de vie restante d'une batterie.

Par exemple, lorsque la température de la batterie diminue, la capacité disponible, c'est-à-dire la capacité qu'elle est capable d'échanger avec une charge, diminue. De même, la valeur de la résistance interne augmente lorsque la température baisse, engendrant une chute consécutive de la tension délivrée en sortie.

Le vieillissement de la batterie peut également provenir de conditions d'usage de la batterie, ainsi que de ses conditions de stockage.

L'estimation de la durée limite d'utilisation d'une batterie permet une optimisation des phases de maintenance de la batterie et ainsi d'éviter toute défaillance éventuelle future.

Les batteries sont en effet entretenues régulièrement, et parfois démontées à des intervalles plus espacés, notamment pour réaliser des séries de tests sur banc d'essai.

L'intervention humaine est dans la plupart des cas incontournable pour ce type d'opération, surtout en cas d'ouverture de la batterie pour réaliser un ajustage du niveau ou de la densité d'électrolyte, pour les batteries Pb-acide/NiCd, par exemple.

L'intégration croissante de nouvelles technologies dans les batteries, telles que la technologie à base de lithium-ion, permet de limiter les entretiens. Les intervalles de maintenance doivent cependant toujours être optimisés afin de réduire le plus possible l'intervention humaine dans le processus de maintenance des batteries et éviter tout démontage de la batterie ou arrêt de service temporaire.

Le contrôle de la batterie repose essentiellement sur l'estimation de l'état de santé de la batterie ou SOH (pour « State of Health », en langue anglaise), et de sa durée de vie restante.

La prédiction de la durée de vie restante d'une batterie est toutefois complexe à mettre en oeuvre. En effet, pour de nombreuses applications, la durée de vie restante d'une batterie est généralement fournie en nombres de cycles. Toutefois, cette formulation ne convient pas aux applications les plus complexes dans lesquelles la batterie est soumise à des conditions de fonctionnement variées tant en mode de stockage de la batterie que lors de son fonctionnement, ces conditions étant imprévisibles et non répétitives.

On connaît déjà, dans l'état de la technique, des procédés permettant de déterminer la durée de vie restante d'une batterie, la durée de vie étant fournie en fonction du nombre de cycles d'utilisation, mis à jour par décomptage.

On pourra se référer au document EP-A-2 933 149 dans lequel on détermine des paramètres d'une batterie rechargeable au cours de cycles multiples de charge et de décharge, ces paramètres permettant d'indiquer la durée de vie restante de la batterie et ses performances. A l'issue de ces phases de charge et de décharge, une capacité restante et une résistance interne sont notamment estimées en se basant sur le courant, la tension et la température de la batterie.

On pourra également se référer au document WO 2005/00 38 00 dans lequel un indicateur d'état de la batterie SOH est délivré en utilisant une fonction qui est mise en oeuvre de manière adaptative lors de tests de la batterie, la durée de vie restante étant estimée à partir des indicateurs SOH en utilisant un modèle de durée de vie de la batterie.

Le document US 2016/259014 A1 décrit un procédé qui permet d'estimer la vie restante d'une batterie (RUL = remaining useful life). Des paramètres primaires (température et tension) sont détectés pendant un cycle d'utilisation de la batterie. En particulier, les minimum/maximum sont enregistrés.

A partir des paramètres primaires (courbes température/tension), le procédé détermine des paramètres secondaires, comprenant divers index calculés. Une première estimation grossière du RUL détermine, à partir des paramètres primaires et secondaires, une classe de batterie qui correspond à un nombre de cycles. Une deuxième estimation plus fine du RUL est faite en se basant sur des paramètres primaires et secondaires optimisés et sur des modèles de régression.

US 2016/349330 A1 décrit un procédé permet d'estimer la vie restante d'une batterie en se basant sur des facteurs de dégradation, comme la température, et un modèle; le modèle est entraîné à l'aide de données comprenant les minimum/maximum de température.

Le but de l'invention est donc de pallier les divers inconvénients de l'état de la technique et de permettre une détermination d'une durée limite d'utilisation d'une batterie qui soit suffisamment fiable et précise pour augmenter les périodes de maintenance, c'est-à-dire la durée entre deux opérations de maintenance consécutives.

L'invention a ainsi pour objet un procédé de détermination d'une durée limite d'utilisation d'une batterie comme défini par la revendication 1, qui comporte :

- une étape de sélection d'une période d'utilisation de la batterie ;
- une étape d'obtention de valeurs de facteurs de dégradation de la batterie pendant la période d'utilisation de la batterie issue de l'étape de sélection ;
- une étape de détermination d'un ou de plusieurs indicateurs de vieillissement de la batterie à partir des valeurs de facteurs de dégradation issues de l'étape d'obtention ;
- une étape d'identification d'intervalles de variation des facteurs de dégradation pendant ladite période d'utilisation, chaque indicateur de vieillissement étant associé à des intervalles de variation propres, les intervalles de variation comprenant chacun une valeur calculée minimale et une valeur calculée maximale desdits facteurs utilisés pendant l'étape de détermination,

l'identification des intervalles de variation des facteurs de dégradation se faisant à partir d'un calcul de valeurs moyennes ($F_{i,moy}$) et d'écarts type ($\sigma_i$) des facteurs de dégradation, les valeurs des facteurs de dégradation étant obtenues pendant la période d'utilisation (P); et

- une étape de prédiction de la durée limite d'utilisation à l'aide du modèle de vieillissement qui comprend les étapes:

   * délivrer une durée limite d'utilisation (D) de la batterie pour chaque condition de fonctionnement correspondant à une combinaison des valeurs minimale et maximale des facteurs de dégradation, et à partir des limites opérationnelles de la batterie et du ou des indicateurs de vieillissement, et
   * retenir la valeur de la durée limite d'utilisation minimale.

Ainsi, la durée limite d'utilisation de la batterie est fondée sur une analyse du fonctionnement de la batterie pendant une période d'utilisation prédéterminée et sur une prédiction de la durée limite d'utilisation faite notamment à partir d'un modèle prédictif combiné à des valeurs limites opérationnelles de la batterie qui permettent de déterminer si les conditions de fonctionnement issues des intervalles de variation des facteurs de dégradation se situent en dehors des limites opérationnelles et permettent ainsi une estimation précise et fiable de la durée limite d'utilisation de la batterie.

Avantageusement, les indicateurs de vieillissement sont obtenus à partir d'un modèle de vieillissement de la batterie en fonction des facteurs de dégradation.

Dans un mode de mise en oeuvre, le procédé comprend une étape supplémentaire d'apprentissage préalable de la batterie au cours de laquelle on détermine des limites opérationnelles de la batterie en fonction des facteurs de dégradation.

De préférence, l'étape de prédiction de la durée limite d'utilisation comprend en outre une phase d'analyse des conditions de fonctionnement en utilisant les valeurs minimale et maximale de chaque facteur de dégradation et les limites opérationnelles de la batterie.

Selon une autre caractéristique du procédé, on utilise un modèle de vieillissement recevant en entrée $2^{m+1}$ valeurs limites de m facteurs de dégradation, et délivrant $2^{m+1}$ valeurs de donnée limite d'utilisation, et l'on retient une valeur minimale des durées limites délivrées.

Par exemple, les indicateurs de vieillissement comprennent la valeur de la résistance interne de la batterie et de la capacité de la batterie.

Les facteurs de dégradation peuvent comprendre la température de la batterie, l'état de charge de la batterie et le nombre de cycles de sollicitation de la batterie.

Avantageusement, on pondère les facteurs de dégradation de la batterie.

L'invention a également pour objet un dispositif de détermination d'une durée limite d'utilisation d'une batterie comme défini dans la revendication 9, le dispositif comprenant :

- une interface de raccordement apte à se brancher à la batterie et à communiquer avec elle pour recevoir de la batterie des valeurs de facteurs de dégradation (Fi) de la batterie, obtenues par la batterie pendant une période sélectionnée d'utilisation (P) de la batterie;
- un modèle de vieillissement de la batterie apte à délivrer des valeurs d'indicateurs de vieillissement ($\Delta C$, $\Delta R$) en fonction des dits facteurs de dégradation de la batterie obtenus pendant la dite période d'utilisation de la batterie ; et
- des moyens apte à identifier des intervalles ($F_{i,max/min}$) de variation des facteurs de dégradation pendant ladite période d'utilisation (P) à partir d'un calcul de valeurs moyennes ($F_{i,moy}$) et d'écarts type ($\sigma_i$) des facteurs de dégradation, chaque indicateur de vieillissement étant associé à des intervalles de variation propres des facteurs de dégradation, et
- des moyens de calcul (11) pour calculer des valeurs minimale et maximale des dits intervalles de variation des facteurs de dégradation qui influent sur les indicateurs de vieillissement;

le modèle de vieillissement délivrant une durée limite d'utilisation de la batterie, pour chaque condition de fonctionnement correspondant à une combinaison des valeurs minimale et maximale des facteurs de dégradation, et à partir des limites opérationnelles de la batterie,
les moyens de calcul étant adaptés pour retenir la valeur limite d'utilisation minimale.

D'autres buts, caractéristiques et avantages de l'invention apparaîtront à la lecture de la description suivante, donnée uniquement à titre d'exemple non limitatif, et faite en référence aux dessins annexés sur lesquels :

- la figure 1 est un schéma synoptique illustrant les principales phases d'un procédé de détermination d'une durée limite d'utilisation d'une batterie conforme à l'invention ; et
- la figure 2 illustre l'architecture générale d'un dispositif correspondant pour déterminer la durée limite d'utilisation d'une batterie.

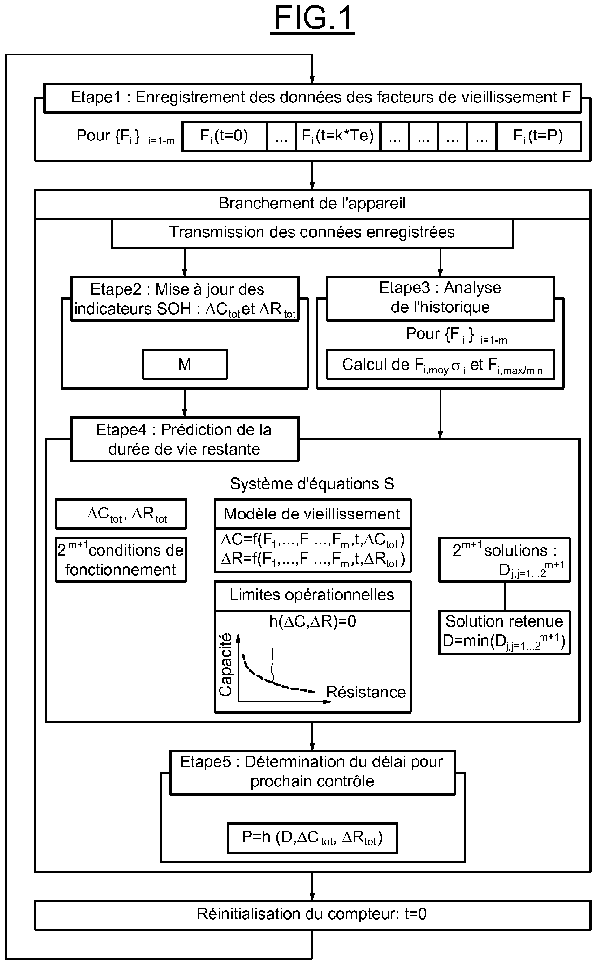

Le procédé illustré à la figure 1 est destiné à estimer la durée de vie restante d'une batterie, en particulier une batterie rechargeable d'accumulateurs électriques embarquée à bord d'un aéronef.

Il est plus particulièrement destiné à estimer la durée limite d'utilisation d'une batterie, en tenant compte de facteurs de dégradation susceptibles d'influer sur la durée de vie de la batterie.

Ce procédé est destiné à prédire l'instant où la batterie ne sera plus capable d'assurer sa fonction d'alimentation lors de son utilisation dans des conditions prédéterminées d'utilisation.

Il permet ainsi de programmer des phases de maintenance à partir d'une prédiction de la durée de vie restante de la batterie.

Dans un mode de mise en oeuvre, ce procédé est mis en oeuvre au sein d'un dispositif qui vient se brancher à la batterie et communiquer avec elle, ce dispositif incorporant tous les moyens matériels et logiciels et pour la mise en oeuvre de ce procédé. Un tel dispositif utilise en particulier un modèle prédictif de la batterie capable de prédire la durée de vie restante de la batterie, de prédire les éventuelles conditions de son utilisation future et de mettre à jour les indicateurs de son état de santé SOH à partir d'une analyse de l'historique d'utilisation de la batterie pendant une période P d'utilisation.

A titre d'exemple, on considère ici que la durée de vie restante est prédite en supposant que les conditions d'utilisation de la batterie pendant la période P d'utilisation sont reproduites lors de phases ultérieures d'utilisation de la batterie.

Toutefois, on ne sort pas du cadre de l'invention lorsque les conditions d'utilisation future de la batterie sont modifiées, le procédé étant capable de prédire ces conditions d'utilisation.

Comme le montre la figure 1, le procédé comprend une première étape 1 d'enregistrement au cours de laquelle un nombre m de facteurs de dégradation de la batterie est identifié pour le profil d'utilisation en cours de la batterie. Ces facteurs $F_{i,\ i=1...m}$ sont enregistrés pendant une période P d'utilisation séparant deux évènements de contrôle de la batterie, mis à jour ultérieurement.

L'échantillonnage des enregistrements dépend de l'application, c'est-à-dire du mode d'utilisation de la batterie. Par exemple, cet échantillonnage est réalisé par unité de temps (nombre d'heures, nombre de jours, ...) ou en nombre d'évènements (cycles de charge et de décharge, ...).

Comme on le voit, ces enregistrements sont effectués périodiquement, selon une période $T_e$, un facteur de dégradation $F_i$ étant enregistré à un instant $k \times T_e$, avec k=1, ...,n, et $P = n \times T_e$.

Lorsque le dispositif de contrôle est branché à la batterie, l'étape 1 d'enregistrement des données est achevée. Les données enregistrées en mémoire dans la batterie sont alors transmises au dispositif.

Lors de l'étape 2 suivante, l'état de santé SOH de la batterie est déterminé ou mis à jour. L'état de santé est ici représenté par deux indicateurs de vieillissement $\Delta C$ et $\Delta R$ désignant respectivement les évolutions de la capacité et de la résistance interne de la batterie.

Le dispositif de contrôle est à cet égard doté d'un modèle de vieillissement M apte à délivrer des valeurs d'indicateurs $\Delta C$ et $\Delta R$ à partir des données enregistrées reçues en entrée. L'étape 3 suivante constitue une étape d'analyse de l'historique d'utilisation de la batterie pendant la période P d'utilisation. La moyenne $F_{i,moy}$ et l'écart type $\sigma_i$ pondérés des valeurs de chaque facteur de dégradation $F_i$ sont calculés. La pondération des moyennes et des écarts type est déterminée à l'aide du modèle de vieillissement. Le modèle permet d'identifier les plages de variation de chaque facteur $F_i$ qui impactent le plus la dégradation de la batterie. En effet, l'influence des facteurs $F_i$ est supposée être différente sur l'évolution de la capacité et de la résistance interne de la batterie.

Au cours de cette étape 3, des ensembles de moyennes $F_{i,moy}$ et d'écarts-type $\sigma_i$ sont déterminés et des poids extraits d'une cartographie sont affectés aux moyennes et écarts type calculés pour chaque indicateur.

Au cours de cette étape, des intervalles de variation des facteurs de vieillissement correspondant à des intervalles d'influence $[F_{i,min},\ F_{i,max}]$ dans la période P sont identifiés pour chacun des indicateurs selon la formule :

$$F_{i,max/min}=F_{i,moy}\pm\sigma_i \qquad (1)$$

En supposant que les conditions opérationnelles futures sont semblables à celles constatées pendant la période P, les limites $F_{i,max/min}$ sont utilisées dans les étapes suivantes du procédé pour la prédiction de la durée de vie restante de la batterie.

Lors de l'étape 4 suivante, on procède à la prédiction de la durée de vie restante de la batterie à partir des intervalles de variation des facteurs de dégradation et de limites opérationnelles de la batterie obtenues par apprentissage préalable en fonction de valeurs d'indicateurs de vieillissement.

Dans l'exemple de mise en oeuvre envisagée, les limites opérationnelles de la batterie sont obtenues par apprentissage préalable lors d'une phase de test de la batterie en fonction des indicateurs de vieillissement $\Delta C$ et $\Delta R$.

Comme le montre la figure 1, les limites opérationnelles de la batterie sont identifiées par une courbe I de fin de vie déterminée en fonction de profils d'usage de la batterie. Ces tests sont effectués, pour chaque profil d'utilisation, et consistent à vérifier si la batterie est capable de fournir le profil d'utilisation qui lui est demandé, en termes de niveau de tension, de niveau de courant, de puissance ou d'énergie électrique, pour une durée ou des plages de durées prédéfinies, pour diverses valeurs de résistance et de capacité interne de la batterie.

La combinaison des limites $F_{i,max/min}$ des m facteurs de dégradation donne, pour chaque indicateur SOH, $2^m$ conditions de fonctionnement écrites sous la forme :

$$\{F1,k,...,Fi,k,...,Fm,k\}k = \{max,min\} \qquad (2)$$

En total, $2^{m+1}$ combinaisons sont identifiées pour le modèle de vieillissement. La résolution du système d'équations S pour ces $2^{m+1}$ entrées donne en sortie $2^{m+1}$ valeurs D durée de vie restante de la batterie. Celle qui est retenue est la valeur minimale trouvée parmi les résultats.

Lors de l'étape 5 suivante, on détermine le délai proposé pour le prochain contrôle P' de la batterie. Ce délai est déterminé à partir d'une fonction h qui dépend de la durée de vie restante D estimée et des indicateurs de vieillissement de la batterie. Par exemple, le délai proposé pour le prochain contrôle P' est défini comme étant la moitié de la durée de vie restante D. Ainsi, par exemple, le délai proposé P' n'est pas égal au délai P de surveillance de la batterie. En effet, la période entre deux contrôles peut dépasser le délai envisagé selon le mode de gestion de la maintenance de la batterie. A l'issue de cette étape 5, le compteur de temps est réinitialisé et une nouvelle période P est déclenchée. Le dispositif de contrôle est ensuite débranché.

Comme indiqué précédemment, le procédé qui vient d'être décrit est avantageusement mis en oeuvre par un dispositif de contrôle qui vient se brancher sur une batterie pour récupérer et analyser les données stockées en mémoire pendant la période P d'utilisation de la batterie. Ce dispositif récupère les données des facteurs de dégradation stockés en mémoire dans la batterie et met à jour l'état de santé de la batterie, prédit sa durée de vie restante et envisage un délai pour le prochain contrôle. Il peut à cet égard, par exemple, envisager une opération de maintenance dans un intervalle de temps compris entre une valeur minimale $T_{min}$ et une valeur maximale $T_{max}$.

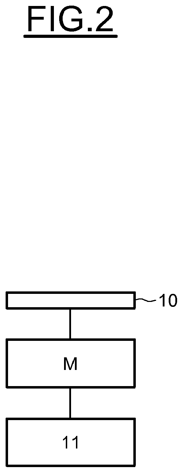

En référence à la figure 2, le dispositif comporte une interface 10 de raccordement électrique à la batterie, un modèle de vieillissement M apte à délivrer des valeurs d'indicateurs de vieillissement en fonction des facteurs de dégradation et des moyens de calcul 11 assurant la mise en oeuvre des étapes décrites précédemment en référence à la figure 1, et en particulier les étapes 3 à 5 pour calculer les valeurs minimale et maximale des facteurs de dégradation qui influent sur les indicateurs de vieillissement et résoudre le système d'équations S des $2^{m+1}$ combinaisons identifiées pour le modèle de vieillissement et délivrer en sortie les $2^{m+1}$ valeurs de durée de vie restante de la batterie pour en extraire la valeur minimale et déterminer le délai pour le prochain contrôle.

Un exemple de mise en oeuvre de l'invention, qui correspond au cas du vieillissement en mode de stockage d'une batterie est maintenant décrit. Dans ce cas, seul le vieillissement calendaire influe sur la durée de vie de la batterie, en fonction de la température ambiante et de l'état de charge SOC de la batterie. L'état de charge est directement obtenu à partir de la tension à vide OVC obtenue aux bornes de la batterie. Les facteurs de dégradation identifiés dans ce cas sont la température et l'état de charge de la batterie. Les enregistrements de la température ambiante et de la tension de la batterie représentent respectivement ces deux facteurs de dégradation. L'échantillonnage des facteurs de dégradation est choisi suivant l'environnement de la batterie. Par exemple, les mesures sont relevées une fois par jour. Par ailleurs, la température est le facteur de dégradation le plus impactant. Les poids les plus élevés sont ainsi attribués aux températures les plus élevées dans le calcul des moyennes et écarts type pondérés.

Lors du fonctionnement en charge et décharge de la batterie, plusieurs facteurs complémentaires interviennent. Il s'agit du courant et d'un paramètre désigné par les anglosaxons par le terme de « DoD » pour « Depth of Discharge ». D'autres facteurs peuvent également intervenir. Ces facteurs peuvent être quantifiés en quantité d'ampères échangés, en nombre de cycles et de sollicitations, ... en fonction de l'application visée et de la connaissance des profils d'utilisation future de la batterie. Le vieillissement calendaire est prépondérant. La contribution de la dégradation ayant d'autres causes peut être prise en compte à titre indicatif. Le procédé peut ainsi être applicable quelle que soit l'application envisagée.

**Revendications**

1. Procédé de détermination d'une durée limite d'utilisation d'une batterie, **caractérisé en ce qu'**il comporte:

    - une étape de sélection d'une période (P) d'utilisation de la batterie ;
    - une étape d'obtention de valeurs de facteurs de dégradation (Fi) de la batterie pendant la période d'utilisation de la batterie issue de l'étape de sélection ;
    - une étape de détermination d'un ou de plusieurs indicateurs de vieillissement ($\Delta C$, $\Delta R$) de la batterie à partir des valeurs de facteurs de dégradation issues de l'étape d'obtention ;
    - une étape d'identification d'intervalles ($F_{i,max/min}$) de variation des facteurs de dégradation pendant ladite période d'utilisation (P), chaque indicateur de vieillissement étant associé à des intervalles de variation propres, les intervalles de variation comprenant chacun une valeur calculée minimale et une valeur calculée maximale desdits facteurs utilisés pendant l'étape de détermination, l'identification des intervalles de variation des facteurs de dégradation se faisant à partir d'un calcul de valeurs moyennes ($F_{i,moy}$) et d'écarts type ($\sigma_i$) des facteurs de dégradation, les valeurs des facteurs de dégradation étant obtenues pendant la période d'utilisation P; et
    - une étape de prédiction de la durée limite d'utilisation (D) à l'aide d'un modèle de vieillissement qui comprend les étapes :

        - délivrer une durée limite d'utilisation (D) de la batterie pour chaque condition de fonctionnement correspondant à une combinaison des valeurs minimale et maximale des facteurs de dégradation, et à partir des limites opérationnelles de la batterie et du ou des indicateurs de vieillissement, et
        - retenir la valeur de la durée limite d'utilisation minimale.

2. Procédé selon la revendication 1, dans lequel les indicateurs de vieillissement sont obtenus à partir du modèle de vieillissement de la batterie en fonction des facteurs de dégradation.

3. Procédé selon la revendication 1 ou 2, comprenant une étape supplémentaire d'apprentissage préalable de la batterie au cours de laquelle on détermine des limites opérationnelles de la batterie en fonction des facteurs de dégradation.

4. Procédé selon la revendication 3, dans lequel l'étape de prédiction de la durée limite d'utilisation comprend une phase d'analyse des conditions de fonctionnement en utilisant les valeurs minimale et maximale ($F_{i, max/min}$) de chaque facteur de dégradation et les limites opérationnelles de la batterie.

5. Procédé selon la revendication 4, dans lequel le modèle de vieillissement (M) reçoit en entrée $2^{m+1}$ valeurs limites de m facteurs de dégradation, et délivre $2^{m+1}$ valeurs de durées limite d'utilisation et dans lequel on retient la valeur minimale des durées limites délivrées.

6. Procédé selon l'une quelconque des revendications 1 à 5, dans lequel les indicateurs de vieillissement comprennent la valeur de la résistance interne de la batterie et de la capacité de la batterie.

7. Procédé selon l'une quelconque des revendications 1 à 6, dans lequel les facteurs de dégradation comprennent la température de la batterie, l'état de charge de la batterie et le nombre de cycles de sollicitations de la batterie.

8. Procédé selon l'une quelconque des revendications 1 à 7, dans lequel on pondère les facteurs de dégradation de la batterie.

9. Dispositif de détermination d'une durée limite d'utilisation d'une batterie, le dispositif comprenant :

    - une interface (10) de raccordement apte à se brancher à la batterie et à communiquer avec elle pour recevoir de la batterie des valeurs de facteurs de dégradation ($F_i$) de la batterie, obtenues par la batterie pendant une période sélectionnée d'utilisation (P) de batterie,
    - un modèle de vieillissement (M) de la batterie apte à délivrer des valeurs d'indicateurs de vieillissement ($\Delta C$,

ΔR) en fonction desdits facteurs de dégradation obtenus pendant ladite période d'utilisation de la batterie ; et
- des moyens aptes à identifier des intervalles ($F_{i,max/min}$) de variation des facteurs de dégradation pendant ladite période d'utilisation (P) à partir d'un calcul de valeurs moyennes ($F_{i,moy}$) et d'écarts type ($\sigma_i$) des facteurs de dégradation, chaque indicateur de vieillissement étant associé à des intervalles de variation propres des facteurs de dégradation, et
- des moyens de calcul (11) pour calculer des valeurs minimale et maximale desdits intervalles de variation des facteurs de dégradation qui influent sur les indicateurs de vieillissement,
le modèle de vieillissement (M) état adapté pour délivrer une durée limite d'utilisation (D) de la batterie, pour chaque condition de fonctionnement correspondant à une combinaison des valeurs minimale et maximale des facteurs de dégradation, et à partir de limites opérationnelles de la batterie et des indicateurs de vieillissement, les moyens de calcul (11) étant adaptés pour retenir la valeur de la durée limite d'utilisation minimale.

**Patentansprüche**

1. Verfahren zum Bestimmen einer Dauer der Haltbarkeit einer Batterie, **dadurch gekennzeichnet, dass** es Folgendes umfasst:

    - einen Schritt des Auswählens eines Nutzungszeitraums (P) der Batterie;
    - einen Schritt des Ermittelns von Werten der Verschlechterungsfaktoren ($F_i$) der Batterie während des Nutzungszeitraums der Batterie aus dem Schritt des Auswählens;
    - einen Schritt des Bestimmens eines oder mehrerer Alterungsindikatoren (ΔC, ΔR) der Batterie anhand der Werte der Verschlechterungsfaktoren aus dem Schritt des Ermittelns;
    - einen Schritt des Identifizierens von Schwankungsbreiten ($F_{i,max/min}$) der Verschlechterungsfaktoren während des Nutzungszeitraums (P), wobei jeder Alterungsindikator eigenen Schwankungsbreiten zugeordnet ist, wobei die Schwankungsbreiten jeweils einen berechneten minimalen Wert und einen berechneten maximalen Wert der während des Schritts des Bestimmens verwendeten Faktoren umfassen, wobei das Identifizieren der Schwankungsbreiten der Verschlechterungsfaktoren anhand der Mittelwerte ($F_{i,moy}$) und der Standardabweichungen ($\sigma_i$) der Verschlechterungsfaktoren erfolgt, wobei die Werte der Verschlechterungsfaktoren während des Nutzungszeitraums P ermittelt werden; und
    - einen Schritt des Vorhersagens der Dauer der Haltbarkeit (D) mit Hilfe eines Alterungsmodells, der die folgenden Schritte umfasst:

        - Bereitstellen einer Dauer der Haltbarkeit (D) der Batterie für jeden Betriebszustand, der einer Kombination aus dem minimalen und dem maximalen Wert der Verschlechterungsfaktoren entspricht, und anhand der Betriebsgrenzen der Batterie und des Alterungsindikators bzw. der Alterungsindikatoren, und
        - Speichern des Werts der minimalen Dauer der Haltbarkeit.

2. Verfahren nach Anspruch 1, wobei die Alterungsindikatoren anhand des Alterungsmodells für die Batterie in Abhängigkeit von den Verschlechterungsfaktoren ermittelt werden.

3. Verfahren nach Anspruch 1 oder 2, das einen zusätzlichen Schritt des vorherigen Erlernens der Batterie umfasst, während dem die Betriebsgrenzen der Batterie in Abhängigkeit von den Verschlechterungsfaktoren ermittelt werden.

4. Verfahren nach Anspruch 3, wobei der Schritt des Vorhersagens der Dauer der Haltbarkeit eine Phase des Analysierens von Betriebsbedingungen unter Verwendung der des minimalen und des maximalen Werts ($F_{i,max/min}$) jedes Verschlechterungsfaktors und der Betriebsgrenzen der Batterie umfasst.

5. Verfahren nach Anspruch 4, wobei das Alterungsmodell (M) am Eingang $2^{m+1}$ Grenzwerte von m Verschlechterungsfaktoren empfängt und $2^{m+1}$ Werte der Dauer der Haltbarkeit bereitstellt, und wobei der minimale Wert der bereitgestellten Haltbarkeitsdaten gespeichert wird.

6. Verfahren nach einem der Ansprüche 1 bis 5, wobei die Alterungsindikatoren den Wert des Innenwiderstands der Batterie und der Kapazität der Batterie umfassen.

7. Verfahren nach einem der Ansprüche 1 bis 6, wobei die Verschlechterungsfaktoren die Temperatur der Batterie, den Ladezustand der Batterie und die Anzahl an Batteriebelastungszyklen umfassen.

8. Verfahren nach einem der Ansprüche 1 bis 7, wobei die Verschlechterungsfaktoren der Batterie gewichtet werden.

9. Vorrichtung zum Bestimmen einer Dauer der Haltbarkeit einer Batterie, wobei die Vorrichtung Folgendes umfasst:

- eine Verbindungsschnittstelle (10), die dazu geeignet ist, an die Batterie angeschlossen zu werden und mit ihr zu kommunizieren, um Werte der Verschlechterungsfaktoren ($F_i$) der Batterie, die durch die Batterie während eines ausgewählten Nutzungszeitraums (P) der Batterie ermittelt wurden, von der Batterie zu empfangen,
- ein Alterungsmodell (M) für die Batterie, das dazu geeignet ist, Werte der Alterungsindikatoren ($\Delta D$, $\Delta R$) in Abhängigkeit von den Verschlechterungsfaktoren bereitzustellen, die während des Nutzungszeitraums der Batterie ermittelt wurden; und
- Mittel, die dazu geeignet sind, Schwankungsbreiten ($F_{i,max/min}$) der Verschlechterungsfaktoren während des Nutzungszeitraums (P) anhand einer Berechnung von Mittelwerten ($F_{i,moy}$) und Standardabweichungen ($\sigma_i$) der Verschlechterungsfaktoren zu identifizieren, wobei jeder Alterungsindikator eigenen Schwankungsbreiten der Verschlechterungsfaktoren zugeordnet ist, und
- Rechenmittel (11) zum Berechnen des minimalen und des maximalen Werts der Schwankungsbreiten der Verschlechterungsfaktoren, die die Alterungsindikatoren beeinflussen,
wobei das Alterungsmodell (M) dazu ausgelegt ist, eine Dauer der Haltbarkeit (D) der Batterie für jede Betriebsbedingung, die einer Kombination aus dem minimalen und dem maximalen Wert der Verschlechterungsfaktoren entspricht, und anhand der Betriebsgrenzen der Batterie und der Alterungsindikatoren bereitzustellen,
wobei die Rechenmittel (11) dazu ausgelegt sind, den Wert der minimalen Dauer der Haltbarkeit zu speichern.

## Claims

1. Method for determining a maximum duration of use of a battery, **characterised in that** it includes:

   - a step of selecting a period (P) of use of the battery;
   - a step of obtaining values of degradation factors ($F_i$) of the battery during the period of use of the battery selected during the selection step;
   - a step of determining one or more indicators of ageing ($\Delta C$, $\Delta R$) of the battery on the basis of the degradation factor values obtained during the obtaining step;
   - a step of identifying intervals ($F_{i,max/min}$) of variation of the degradation factors during said period of use (P), each ageing indicator being associated with actual intervals of variation, the intervals of variation each comprise a minimum computed value and a maximum computed value of said factors used during the determination step, the intervals of variation of the degradation factors being identified on the basis of a computation of the mean ($F_{i,mean}$) and standard deviation ($\sigma_i$) values of the degradation factors, the values of the degradation factors being obtained during the period of use (P); and
   - a step of predicting the maximum duration of use (D) on the basis of an ageing model comprising the steps:

     generating a maximum duration of use (D) of the battery, for each operating condition corresponding to a combination of the minimum and maximum values of the degradation factors, and on the basis of the operating limits of the battery and the ageing indicator(s), and
     retaining the minimum value of the duration of use.

2. Method according to claim 1, wherein the ageing indicators are obtained on the basis of the ageing model for the battery as a function of the degradation factors.

3. Method according to one of claims 1 and 2, comprising an additional battery prior training step, during which the operating limits of the battery are determined as a function of the degradation factors.

4. Method according to claim 3, wherein the step of predicting the maximum duration of use comprises a phase of analysing the operating conditions using the minimum and maximum values ($F_{i,\,max/min}$) of each degradation factor and the operating limits of the battery.

5. Method according to claim 4, wherein the ageing model (M) receives, at the input, $2^{m+1}$ limit values of m degradation factors, and generates $2^{m+1}$ maximum duration of use values, and wherein the minimum value of the maximum durations generated is retained.

6. Method according to any of claims 1 to 5, wherein the ageing indicators comprise the value of the internal resistance of the battery and of the capacity of the battery.

7. Method according to any of claims 1 to 6, wherein the degradation factors comprise the temperature of the battery, the state of charge of the battery and the number of battery solicitation cycles.

8. Method according to any of claims 1 to 7, wherein the battery degradation factors are weighted.

9. Device for determining a maximum duration of use of a battery, the device comprising:

- a connection interface (10) adapted to be connected to the battery and to communicate therewith to receive values of the degradation factors ($F_i$) from the battery, obtained from the battery during a selected period of use (P) of battery,
- an ageing model (M) for the battery capable of generating ageing indicator ($\Delta C$, $\Delta R$) values as a function of said degradation factors obtained during said period of use of the battery; and
- means adapted to identify intervals (Fi,max/min) of variation of the degradation factors during said period of use (P) on the basis of a computation of the mean (Fi,mean) and standard deviation ($\sigma_i$) values of the degradation factors, each ageing indicator being associated with actual intervals of variation of the degradation factors, and
- computation means (11) for computing minimum and maximum values of said degradation factors influencing the ageing indicators,
the ageing model (M) being adapted to generate a maximum duration of use (D) of the battery, for each operating condition corresponding to a combination of the minimum and maximum values of the degradation factors, and on the basis of the operating limits of the battery and the ageing indicators,
the computation means (11) being adapted to retain the minimum value of the duration of use.

# FIG.1

Etape1 : Enregistrement des données des facteurs de vieillissement F

Pour $\{F_i\}_{i=1\text{-}m}$ | $F_i(t=0)$ | ... | $F_i(t=k*Te)$ | ... | ... | ... | ... | $F_i(t=P)$

Branchement de l'appareil

Transmission des données enregistrées

Etape2 : Mise à jour des indicateurs SOH : $\Delta C_{tot}$ et $\Delta R_{tot}$

M

Etape3 : Analyse de l'historique

Pour $\{F_i\}_{i=1\text{-}m}$

Calcul de $F_{i,moy}\,\sigma_i$ et $F_{i,max/min}$

Etape4 : Prédiction de la durée de vie restante

Système d'équations S

$\Delta C_{tot}$, $\Delta R_{tot}$

$2^{m+1}$ conditions de fonctionnement

Modèle de vieillissement

$\Delta C=f(F_1,...,F_i...,F_m,t,\Delta C_{tot})$
$\Delta R=f(F_1,...,F_i...,F_m,t,\Delta R_{tot})$

Limites opérationnelles

$h(\Delta C,\Delta R)=0$

Capacité — Résistance

$2^{m+1}$ solutions : $D_{j,j=1...2^{m+1}}$

Solution retenue $D=min(D_{j,j=1...2^{m+1}})$

Etape5 : Détermination du délai pour prochain contrôle

$P=h\,(D,\Delta C_{tot},\Delta R_{tot})$

Réinitialisation du compteur: t=0

# FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2933149 A
- WO 2005003800 A
- US 2016259014 A1
- US 2016349330 A1